# NEUE EUROPÄISCHE PATENTSCHRIFT

(11) **EP 2 442 427 B2**
(45) Veröffentlichungstag und Bekanntmachung des Hinweises auf die Entscheidung über den Einspruch: **11.11.2020**
(45) Hinweis auf die Patenterteilung: 20.07.2016
(21) Anmeldenummer: 11008222.9
(22) Anmeldetag: 12.10.2011
(51) Int. Cl.: H02J 7/00, H04L 29/12, H01M 10/48, G01R 31/36, H01M 10/46

(54) **Akkumulator-Kontrollvorrichtung, sowie Verfahren und System zur elektrischen Hilfsversorgung**
Battery control device and method and system for electric auxiliary supply
Dispositif de contrôle d'accumulateur ainsi que procédé et système d'alimentation électrique auxiliaire

(30) Priorität: 13.10.2010 DE 102010048188
(43) Veröffentlichungstag der Anmeldung: 18.04.2012
(73) Patentinhaber: Phoenix Contact GmbH & Co. KG, 32825 Blomberg (DE)
(72) Erfinder: Henkel, Hartmut, 32825 Blomberg (DE); Heinemann, Michael, 32791 Lage (DE); Neuendorf, Andreas, 32839 Steinheim (DE); Wattenberg, Mike, 33818 Leopoldhöhe (DE)
(74) Vertreter: Kampfenkel, Klaus

(56) Entgegenhaltungen:
- EP-A1- 1 775 793
- EP-A1- 2 081 038
- CN-A- 101 794 919
- US-B1- 6 184 656

## Beschreibung

Die vorliegende Erfindung betrifft im allgemeinen Akkumulator-betriebene unterbrechungsfreie Stromversorgungssysteme. Insbesondere betrifft die vorliegende Erfindung die optimale Kontrolle der Ladung und Entladung der in einem derartigen System verwendeten Akkumulatoren.

In vielen elektrischen Anlagen werden Systeme zur unterbrechungsfreien Stromversorgung (USV) zur Sicherstellung des Betriebs der elektrischen Anlagen unabhängig von Störungen im Energieversorgungsnetz verwendet. Eine USV dient dazu, bei einer Störung der normalen Energieversorgung eine hilfsweise Energieversorgung bereitzustellen. Daher wird im Folgenden für USV auch der Begriff der elektrischen Hilfsversorgung verwendet.

Typischerweise werden zur hilfsweisen Stromversorgung Akkumulatoren eingesetzt, die an eine elektrische Hilfsversorgungsvorrichtung angeschlossen sind und eine an die elektrische Hilfsversorgungsvorrichtung angeschlossene Last hilfsweise mit elektrischer Energie versorgen. Ein Akkumulator ist ein Speicher für elektrische Energie, typischerweise auf Basis eines elektrochemischen Systems, welcher eine oder mehrere Sekundärzellen umfasst, die zur Erhöhung der Gesamtspannung in Reihe oder zur Erhöhung der Kapazität parallel geschaltet sein können. Im Folgenden wird der Begriff Batterie für aufladbare Batterien und somit synonym für Akkumulator verwendet.

Während des Normalbetriebs des Energieverteilungsnetzes wird von der elektrischen Hilfsversorgungsvorrichtung elektrische Energie sowohl an die angeschlossene Last als auch an die Batterie geliefert. Wenn eine Störung im Energieversorgungsnetz auftritt, beginnt sich die Batterie zur Last hin zu entladen, deren elektrische Energieversorgung somit nicht gestört wird. Wenn das Energieverteilungsnetz zu seinem normalen Betrieb zurückkehrt, erfolgt wiederum eine Lieferung von elektrischer Energie sowohl an die Last als auch an die Batterie.

Bei Anlagen mit unterbrechungsfreien Stromversorgungen (USV) mit hohen Erwartungen an die Verfügbarkeit ist die Batterie der USV das Element, das entscheidend die mögliche Dauer des Batteriebetriebs, also die mögliche Pufferzeit, sowie die Lebensdauer der Anlage und somit die Verfügbarkeit bestimmt.

Daher kommt dem Batteriemanagement einer USV eine große Bedeutung zu. Eine Batterie, die typgerecht behandelt wird, erhöht die Verfügbarkeit der Anlage nennenswert. Ein wesentliches Element des Batteriemanagements ist die Ladeeinheit, die wesentlich zur Erhaltung der Qualität der Batterie beitragen kann.

Um die Kapazität einer Batterie möglichst gut ausnutzen zu können, wird die Ladeschlussspannung möglichst hoch eingestellt. Auf diese Weise wird viel Energie in der Batterie gespeichert. Um andererseits die Lebensdauer einer Batterie zu maximieren, kann eine etwas kleinere Ladeschlussspannung verwendet werden. Auf diese Weise wird die Kapazität der Batterie zugunsten der längeren Lebensdauer allerdings nicht ganz ausgenutzt.

Mit einer exakt definierten Ladeschlussspannung kann also das Verhältnis zwischen der Lebensdauer der Batterie und der möglichen Pufferzeit bestimmt werden. Die erforderliche Ladeschlussspannung ändert sich mit der Temperatur der Batterie. Eine USV, welche die Batterietemperatur bei der Ladung berücksichtigt, schont die Batterie und maximiert die Lebensdauer der Batterie und die mögliche Pufferzeit.

Aus DE 198 34 740 A1 ist eine Batterie bekannt, welche zur Erzielung einer langen Lebensdauer und einem guten Stromabgabevermögen eine integrierte Überwachungsvorrichtung aufweist, wobei mittels Sensoren unterschiedliche Betriebszustände der Batterie erfasst, gespeichert und mit gespeicherten Werten verglichen werden und daraus Aussagen über den Ladezustand und den allgemeinen technischen Zustand der Batterie abgeleitet werden.

Aus EP 1 775 793 A1 ist ein Verfahren und eine Vorrichtung zur Ermittlung der Lebensdauer eines Nickel-Metallhydrid-Akkumulators bekannt, wobei die Nutzleistung und die Umgebungstemperatur des Akkumulators gemessen werden und aus diesen Messwerten auf Basis einer zuvor ermittelten Beziehung dieser Werte zur Lebensdauer des Akkumulators eine erwartete Lebensdauer bestimmt wird, aus welcher durch Abziehen eines oder mehrerer Reduktionswerte eine Restlebensdauer des Akkumulators ermittelt wird. Ein dem Akkumulator vorgeschaltetes Bauteil zum Ermitteln der Lebensdauer umfasst Einrichtungen zum Ermitteln der Nutzleistung, der Umgebungstemperatur am Installationsort des Akkumulators, der Akkumulatortemperatur, sowie der Anzahl der Entladezyklen, welche jeweils mit einer ebenfalls in dem Bauteil angeordneten Kontrolleinrichtung verbunden sind, die aus den ermittelten Werten einen Wert für die Restlebensdauer des Akkumulators ermittelt und diesen Wert einer Anzeigeeinrichtung zuführt. Ferner wird der Wert für die Restlebensdauer mittels eines Kommunikationsmittels zu einer unterbrechungsfreien Stromversorgung übertragen, so dass das Laden des Akkumulators durch eine in dem Bauteil zum Ermitteln der Lebensdauer angeordnete Ladekontrolleinrichtung gesteuert wird.

EP 0 980 131 A2 beschreibt ein Verfahren und eine Vorrichtung zur Überwachung wenigstens eines zur Notversorgung von elektrischen und/oder elektronischen Verbrauchern, insbesondere von Zentralbatterie-Notlichtsystemen, zuschaltbaren Batteriesatzes, wobei, um frühzeitig den Ausfall einzelner oder mehrerer Einzelbatterien zu detektieren und dadurch eine höhere Systemverfügbarkeit zu gewährleisten, neben der Gesamtspannung über zumindest eine Spannungsanzapfung des Batteriesatzes eine weitere Spannung bezüglich Plus- und Minus-Anschluß gemessen wird, ein Differenzwert dieser Meßwerte ermittelt und ein Differenzwertsignal an Steuer- und/oder Ladeeinrichtung über eine Verbindung übertragen wird.

US 6,137,265 A beschreibt ein Verfahren zum schnellen Laden eines Akkumulators, insbesondere eines Lithium-Ionen-Akkumulators, wobei verschiedene Stromimpulsformen beschrieben werden, um die Gesamtladezeit zu reduzieren, wobei ein wiederaufladbares Batterie-Pack vorgesehen ist, in welchem zwei Batteriezellen, ein Batterie-Controller, sowie als Cell Protection & Metering Circuit und Second Protection Circuit bezeichnete Schaltungen integriert sind.

Bei industriellen USVs befindet sich die elektrische Hilfsversorgungsvorrichtung, welche die Elektronik der USV beinhaltet, typischerweise in einem Gehäuse, das zum Beispiel auf einer Hutschiene montiert wird, die Batterie jedoch kann entfernt an einer anderen Stelle montiert sein. Von der elektrischen Hilfsversorgungsvorrichtung gemessene Werte der Batteriespannung weichen aufgrund des Spannungsabfalls auf der Leitung zwischen der Batterie und der USV von der tatsächlichen Batteriespannung ab. Auch eine von der elektrischen Hilfsversorgungsvorrichtung, beispielsweise mittels eines in der Elektronik angeordneten Sensors, gemessene Temperatur weicht gegebenenfalls von der tatsächlichen Batterietemperatur ab.

Diese Abweichungen können typischerweise von der elektrischen Hilfsversorgungsvorrichtung nicht korrigiert werden, so dass die Batterie nicht optimal geladen wird.

Der Erfindung liegt daher die Aufgabe zugrunde, einen Weg aufzuzeigen, wie die Kontrolle der Ladung und/oder Entladung der in einer elektrischen Hilfsversorgung verwendeten Akkumulatoren verbessert werden kann, insbesondere wenn elektrische Hilfsversorgungsvorrichtung und Akkumulator entfernt voneinander angeordnet sind.

Diese Aufgabe wird durch ein System zur elektrischen Hilfsversorgung gemäß Anspruch 1, sowie durch ein Verfahren gemäß Anspruch 2 gelöst. Vorteilhafte Ausführungsformen und Weiterbildungen sind in den jeweiligen Unteransprüchen angegeben.

Dementsprechend sieht die Erfindung eine Akkumulator-Kontrollvorrichtung vor, welche einen ersten elektrischen Anschluss zum Anschließen an einen lokalen Akkumulator und einen mit dem ersten elektrischen Anschluss verbundenen zweiten elektrischen Anschluss zum Anschließen an eine entfernte elektrische Hilfsversorgungsvorrichtung aufweist. Die Akkumulator-Kontrollvorrichtung ist somit vorzugsweise in räumlicher Nähe eines angeschlossenen Akkumulators angeordnet. Die Akkumulator-Kontrollvorrichtung ist als Vorschaltgerät für einen Akkumulator ausgebildet.

Die Akkumulator-Kontrollvorrichtung weist eine Kontrolleinheit auf, welche zum Messen wenigstens eines Parameters eines an den ersten elektrischen Anschluss angeschlossenen Akkumulators und/oder eines Umgebungsparameters ausgebildet ist. Zum Verbinden der Kontrolleinheit mit der entfernten elektrischen Hilfsversorgungsvorrichtung ist eine Kommunikationsschnittstelle vorgesehen, wobei die Kontrolleinheit dazu ausgebildet ist, gemessene Parameterwerte und/oder aus gemessenen Parameterwerten berechnete Werte über die Kommunikationsschnittstelle zu der entfernten elektrischen Hilfsversorgungsvorrichtung zu übertragen.

Die Akkumulator-Kontrollvorrichtung kann vorteilhaft mit einem angeschlossenen Akkumulator eine gemeinsame Baueinheit bilden. Auf diese Weise wird vorteilhaft eine intelligente, zur Datenkommunikation mit einer elektrischen Hilfsversorgungsvorrichtung ausgebildete Akkumulatoreinheit bereitgestellt.

Ein Kerngedanke der Erfindung ist darin zu sehen, einen Weg aufzuzeigen, wie bei einer USV, insbesondere im industriellen Umfeld, bei der die elektrische Hilfsversorgungsvorrichtung und der Akkumulator entfernt voneinander angeordnet sind, zu jeder Zeit die aktuelle Spannung an den Klemmen des Akkumulators sowie die aktuelle Temperatur der Batterie zu ermitteln und der elektrischen Hilfsversorgungsvorrichtung bereitzustellen, um durch die Kenntnis dieser exakten Parameter die Zuverlässigkeit und die Brauchbarkeitsdauer des Akkumulators signifikant zu steigern.

Zu diesem Zweck ist vorzugsweise wenigstens eine mit der Kontrolleinheit verbundene Messeinrichtung vorgesehen, welche insbesondere zum Messen der Akkumulatorspannung, des Akkumulatorstroms, des Innenwiderstands des Akkumulators, oder zum Messen eines Umgebungsparameters, insbesondere der Temperatur, ausgebildet ist.

Die Kontrolleinheit umfasst eine elektronische Schaltung sowie vorteilhaft einen Mikrocontroller. Da die Akkumulator-Kontrollvorrichtung vorzugsweise direkt am Akkumulator montiert oder im Gehäuse des Akkumulators untergebracht ist, nimmt die Kontrolleinheit die gewünschten Messwerte direkt an der Batterie auf. So wird vorteilhaft die Akkumulatorspannung direkt an den Klemmen des Akkumulators gemessen, und die Temperatur wird vorzugsweise entweder auf der Akkumulatorelektronik oder mit einem Sensor direkt am Gehäuse des Akkumulators gemessen.

Dementsprechend umfasst die Messeinrichtung vorzugsweise wenigstens einen Sensor, welcher in Kontakt mit einem an den ersten elektrischen Anschluss angeschlossenen Akkumulator angeordnet ist.

In einer bevorzugten Ausführungsform umfasst die Akkumulator-Kontrollvorrichtung ferner einen nichtflüchtigen Speicher, in welchem Kenndaten wenigstens eines anschließbaren Akkumulators gespeichert sind. Diese Kenndaten umfassen vorzugsweise Kenndaten, die zur Durchführung einer Ladungsbilanzierung dienen. Zu diesem Zweck ist die Kontrolleinheit vorteilhaft dazu ausgebildet, in Abhängigkeit des gemessenen Akkumulatorstroms und der gespeicherten Kenndaten eine Ladungsbilanzierung (State Of Charge, SOC) durchzuführen und so den Ladezustand des Akkumulators zu überwachen. Zur Strommessung dient beispielsweise ein Shunt-Widerstand. Vorteilhaft umfasst die Akkumulator-Kontrolleinrichtung ferner eine Einrichtung zur Anzeige des Ladezustands, damit Bedienpersonal vor Ort den Ladezustand prüfen kann. Um den Energieverbrauch der Ladezustandsanzeige gering zu halten, ist diese vorzugsweise manuell aktivierbar und deaktiviert sich automatisch nach einem vorgegebenen Zeitintervall nach Aktivierung wieder.

Um die Leitung zwischen Akkumulator und elektrischer Hilfsversorgungsvorrichtung gegen Kurzschluss und Überlast zu schützen, umfasst die Akkumulator-Kontrollvorrichtung vorzugsweise ein zwischen den ersten und den zweiten elektrischen Anschluss geschaltetes Leitungsschutzelement.

Die Datenkommunikation zwischen Akkumulator-Kontrollvorrichtung und elektrischer Hilfsversorgungsvorrichtung erfolgt vorzugsweise über einen Bus, insbesondere einen seriellen Bus, insbesondere ausgebildet als LIN (Local Interconnect Network)-Bus. Auch wenn der LIN-Bus aufgrund seiner Einfachheit bevorzugt ist, kann auch jedes andere geeignete Bussystem eingesetzt werden.

Die Akkumulator-Kontrollvorrichtung ist zum Betrieb mit einem angeschlossene Lithium-Ionen oder Lithium-Polymer-Akkumulator mit einer Mehrzahl von Akkumulatorzellen ausgebildet, wobei die Akkumulator-Kontrollvorrichtung eine Überwachungseinrichtung zum Überwachen der Zellspannungen des Akkumulators und eine Balancer-Einrichtung zum Balancieren der Zellspannungen umfasst, wobei die Kontrolleinheit dazu ausgebildet ist, bei Erkennen einer Überladung oder Tiefentladung einer Akkumulatorzelle die Verbindung zwischen dem ersten und dem zweiten elektrischen Anschluss zu unterbrechen. Die Balancer-Einrichtung ist beispielsweise dazu ausgebildet, während des Ladevorgangs des Akkumulators die Ladeenergie der Zellen, welche ein höheres Spannungslevel aufweisen, durch einen Widerstand in Wärme umzuwandeln, um so die Zellspannungen auszubalancieren.

Die Akkumulator-Kontrollvorrichtung weist eine intern dauerhaft gespeicherte, eindeutige Identifikationsinformation, beispielsweise in Form einer Seriennummer, auf.

Ein erfindungsgemäßes System zur elektrischen Hilfsversorgung umfasst eine elektrische Hilfsversorgungsvorrichtung und wenigstens einen an die elektrische Hilfsversorgungsvorrichtung entfernt angeschlossenen Akkumulator, wobei jedem Akkumulator eine zugeordnete Akkumulator-Kontrollvorrichtung wie oben beschrieben lokal vorgeschaltet ist.

Werden mehrere Akkumulator-Kontrollvorrichtungen an eine elektrische Hilfsversorgungsvorrichtung angeschlossen, ist eine Adressierung der Akkumulator-Kontrollvorrichtungen erforderlich. Eine solche Adressierung kann mittels der Seriennummer erfolgen. Da diese jedoch typischerweise eine große Datenlänge aufweist, wird alternativ eine temporäre Kommunikations-ID verwendet, welche vorzugsweise von der elektrischen Hilfsversorgungsvorrichtung in Abhängigkeit der Seriennummer zugewiesen wird. Zu diesem Zweck weist die Akkumulator-Kontrollvorrichtung einen nichtflüchtigen Speicher zum Speichern einer temporären Kommunikations-ID auf.

Ein Verfahren zum Kontrollieren eines oben beschriebenen Systems zur elektrischen Hilfsversorgungs sieht vor, dass das Laden und/oder Entladen des wenigstens einen entfernt angeschlossenen Akkumulators durch die elektrische Hilfsversorgungsvorrichtung in Abhängigkeit wenigstens eines gemessenen und/oder aus Messgrößen berechneten Parameters gesteuert wird, und wobei der wenigstens eine Parameter von der zugeordneten Akkumulator-Kontrollvorrichtung an die elektrische Hilfsversorgungsvorrichtung übermittelt wird.

Je nach Einsatzzweck erfolgt die Parameterübermittlung vorteilhaft auf Anforderung der elektrischen Hilfsversorgungsvorrichtung und/oder in vorgegebenen Zeitabständen. Die Parameter, welche von einer Akkumulator-Kontrollvorrichtung ermittelt und an die elektrische Hilfsversorgungsvorrichtung übermittelt werden, umfassen beispielsweise die Akkumulatorspannung, den Akkumulatorstrom, den Innenwiderstand des Akkumulators, den Ladezustand des Akkumulators, und/oder einen Umgebungsparameter, wie insbesondere die Akkumulatortemperatur.

Zu Adressierungszwecken weist die elektrische Hilfsversorgungsvorrichtung jeder angeschlossenen Akkumulator-Kontrollvorrichtung eine temporäre Kommunikations-ID zu, und zwar in Abhängigkeit einer in der jeweiligen Akkumulator-Kontrollvorrichtung dauerhaft hinterlegten Identifikationsinformation.

Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.

Es zeigen:
- Fig. 1:: schematisch den prinzipiellen Aufbau einer bevorzugten Ausführungsform eines erfindungsgemäßen Systems zur elektrischen Hilfsversorgung,
- Fig. 2:: schematisch eine bevorzugte Ausführungsform eines erfindungsgemäßen Systems zur elektrischen Hilfsversorgung, welches eine Mehrzahl von Akkumulatoren umfasst,
- Fig. 3:: schematisch eine bevorzugte Ausführungsform einer erfindungsgemäßen Akkumulator-Kontrollvorrichtung mit angeschlossenem Akkumulator und internem Temperatursensor,
- Fig. 4:: schematisch eine bevorzugte Ausführungsform einer erfindungsgemäßen Akkumulator-Kontrollvorrichtung mit angeschlossenem Akkumulator, wobei ein Temperatursensor am Akkumulator angeordnet ist,
- Fig. 5:: schematisch die in Fig. 4 dargestellte Ausführungsform mit Stromsensor zur Ladezustandsermittlung,
- Fig. 6:: schematisch die in Fig. 5 dargestellte Ausführungsform mit Ladezustandsanzeige,
- Fig. 7:: schematisch eine bevorzugte Ausführungsform einer erfindungsgemäßen Akkumulator-Kontrollvorrichtung mit angeschlossenem Akkumulator und einer Messeinrichtung zur Bestimmung des Innenwiderstands des Akkumulators, und
- Fig. 8:: schematisch eine bevorzugte Ausführungsform einer erfindungsgemäßen Akkumulator-Kontrollvorrichtung mit angeschlossenem Lithium-Ionen-Akkumulator.

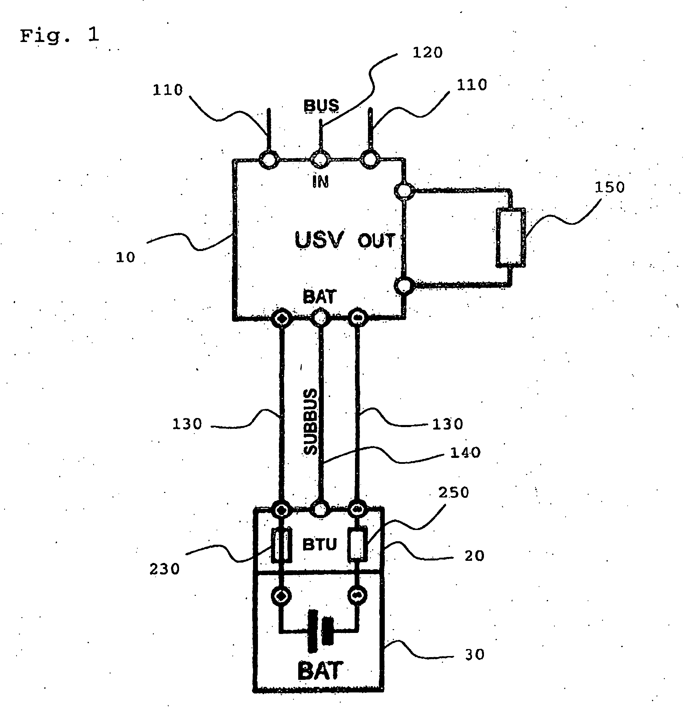

In Fig. 1 ist ein System zur elektrischen Hilfsversorgung dargestellt, welches eine elektrische Hilfsversorgungsvorrichtung 10 umfasst, die der Versorgung einer angeschlossenen Last 150 mit elektrischer Energie dient und zu diesem Zweck über Leitungen 110 an ein Stromnetz angeschlossen ist. Fällt das Stromnetz aus, so wird elektrische Energie von der aufladbaren Batterie 30 zu der Last 150 geführt und die Batterie 30 dementsprechend entladen. Steht das Stromnetz wieder zur Verfügung wird die Last 150 wieder direkt aus dem Stromnetz gespeist und die Batterie 30 wieder aufgeladen. Das Laden der Batterie 30 erfolgt mit einer von der elektrischen Hilfsversorgungsvorrichtung 10 gesteuerten Ladeschlussspannung, die vorzugsweise in Abhängigkeit des Batterietyps, der Batteriespannung sowie der Batterietemperatur eingestellt wird.

Die für einen optimalen Ladevorgang erforderlichen Parameter werden der elektrischen Hilfsversorgungsvorrichtung 10 von einer der Batterie 30 vorgeschalteten Akkumulator-Kontrollvorrichtung 20 über einen Bus 140 übermittelt, wobei die Akkumulator-Kontrollvorrichtung 20 für diesen Zweck einen Mikrocontroller aufweist, welcher das Messen, Auswerten und Übertragen von Daten steuert.

Die Batterie 30 ist über zwei, durch die Akkumulator-Kontrollvorrichtung 20 geleitete, stromtragfähige Leitungen 130 mit der elektrischen Hilfsversorgungsvorrichtung 10 verbunden. Die Datenkommunikation über den Bus 140 erfolgt über eine dritte Leitung. Diese Leitung stellt keine hohen Anforderungen an die Stromtragfähigkeit.

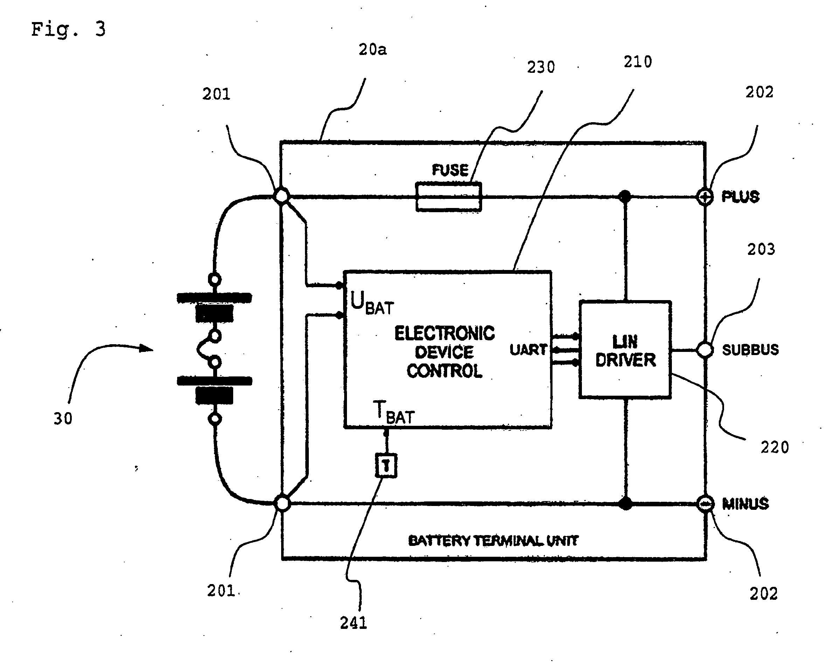

Die Leistungsleitungen 130 sind durch ein in der Akkumulator-Kontrollvorrichtung 20 angeordnetes Leitungsschutzelement 230 abgesichert. Ferner ist bei der in Fig. 1 dargestellten Ausführungsform ein Shunt-Widerstand 250 zur Strommessung vorgesehen. Vorzugsweise umfasst die Akkumulator-Kontrollvorrichtung 20 eine in Fig. 1 nicht dargestellte Kontrolleinheit 210 mit einem Mikrocontroller zur Gerätesteuerung, sowie weitere oder andere elektronische Bauteile. Der interne Aufbau der Akkumulator-Kontrollvorrichtung 20 ist in den Figuren 3 bis 8 für verschiedene bevorzugte Ausführungsformen 20a bis 20f im Detail dargestellt.

Die elektrische Hilfsversorgungsvorrichtung 10 kann vorteilhaft über einen Bus 120 mit einem nicht dargestellten übergeordneten Steuergerät verbunden sein.

Die Akkumulator-Kontrollvorrichtung 20 enthält nichtflüchtig gespeicherte konstante Daten wie Batterietyp, Nennspannung, Nennkapazität, Revision der Hardware, Revision der Firmware, Art des Ladeverfahrens, Art der Ladungserhaltung, Ladestrom, Ladeschlussspannung, Entladeschlussspannung, Temperaturkoeffizient der Ladeschlussspannung, Herstellungsdatum des Batteriemoduls, Seriennummer des Batteriemoduls, Kommunikationsadresse.

Es können eine oder mehrere Batterien 30 mit zugeordneter Kontrollvorrichtung 20 gemeinsam an einer Hilfsversorgungsvorrichtung 10 betrieben werden. Somit kann die Pufferzeit durch die Anzahl der Batteriemodule skaliert werden.

Damit die Kontrollvorrichtung 20 eine lagernde Batterie 30 nicht belastet, wechselt der Mikrocontroller vorteilhaft nach einer Zeitdauer von beispielsweise 2 Minuten, während der keine Daten empfangen wurden, in einen Betriebsmodus, in welchem nur minimale Energie verbraucht wird. Erneuter Datenverkehr auf dem Kommunikationskanal weckt den Mikrocontroller.

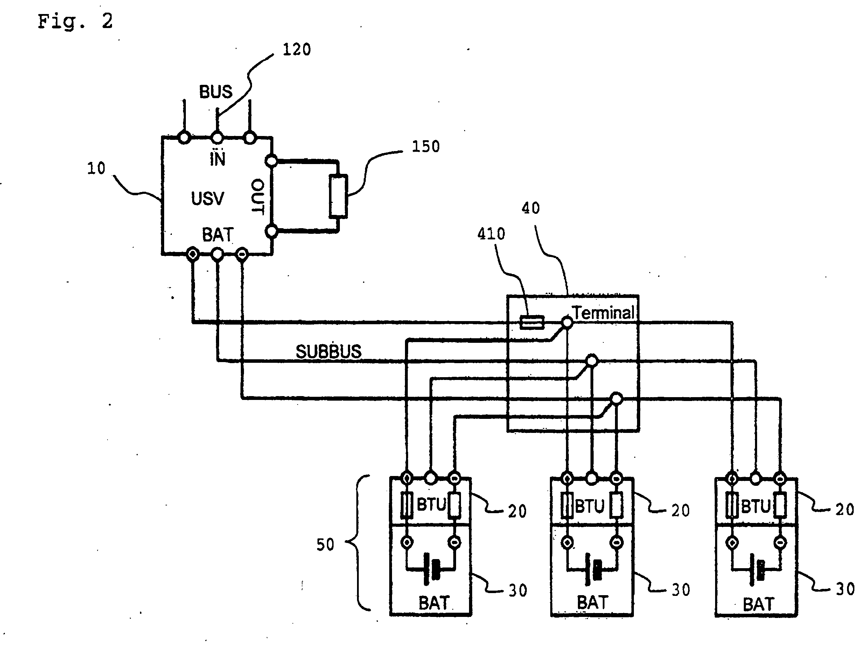

Fig. 2 zeigt eine bevorzugte Ausführungsform in welcher mehrere Batterien 30 mit der Hilfsversorgungsvorrichtung 10 verbunden sind. In der dargestellten Ausführungsform sind die Batterien 30 zunächst mit einem Klemmenblock (Terminal) 40 zusammengeschaltet. Die Leitungen zwischen den Batterien und dem Terminal sind durch Sicherungen in den den Batterien 30 jeweils vorgeschalteten Kontrollvorrichtungen 20 gegen Überlastung geschützt. Die Leitungen zwischen dem Terminal 40 und der Hilfsversorgungsvorrichtung 10 werden durch eine separate Sicherung 410 geschützt. Die Datenleitungen aller Kontrollvorrichtungen 20 werden im Terminal 40 einfach miteinander verbunden und zur Hilfsversorgungsvorrichtung 10 geführt.

Auf diese Weise können mehrere "intelligente" Batterieeinheiten 50, jeweils umfassend eine Batterie 30 und eine zugeordnete Kontrollvorrichtung 20, an eine Hilfsversorgungsvorrichtung 10 angeschlossen werden. Um mit jeder Batterieeinheit 50 separat kommunizieren zu können, muss die jeweilige Kontrollvorrichtung (Battery Terminal Unit, BTU) 20 eindeutig adressierbar sein. Hierzu kann beispielsweise eine eindeutige Seriennummer jeder BTU 20 dienen. Da diese jedoch typischerweise sehr lang ist und somit den Telegrammverkehr unnötig aufblähen würde, weist die Hilfsversorgungsvorrichtung 10 vorzugsweise jeder BTU 20 aufgrund ihrer Seriennummer eine eindeutige Kommunikationsadresse zu und übermittelt diese an die jeweilige BTU 20, welche diese in einem nichtflüchtigen Speicher speichert.

Eine bevorzugte Variante für diese Zuweisung umfasst die folgenden Schritte:
1. Per Broadcast-Telegramm werden alle Kommunikationsadressen der angeschlossenen BTUs 20 gelöscht, bzw. mit einer ungültigen Kommunikationsadresse überschrieben.
2. Per Broadcast-Telegramm fragt die Hilfsversorgungsvorrichtung 10 nach Teilnehmern, die noch keine Kommunikationsadresse besitzen.
3. Die BTUs 20, die keine gültige Kommunikationsadresse besitzen, antworten nach einer zufälligen Wartezeit, welche beispielsweise einen Wert zwischen 100 ms und 1000 ms hat. Bevor eine BTU 20 antwortet, prüft sie, ob der Kommunikationskanal frei ist. Die Antwort der BTU 20 beinhaltet die eindeutige Seriennummer der BTU 20.
4. Die Hilfsversorgungsvorrichtung 10 teilt jeder BTU 20 bezogen auf ihre Seriennummer eine Kommunikationsadresse mit. Diese wird in der BTU 20 nichtflüchtig gespeichert.
5. Die Hilfsversorgungsvorrichtung 10 fragt solange nach neuen Teilnehmern, bis sie keine Antwort mehr bekommt und alle BTUs 20 adressiert sind.

Fig. 3 zeigt eine bevorzugte Ausführungsform einer Akkumulator-Kontrollvorrichtung 20a mit einem an einen ersten elektrischen Anschluss 201 angeschlossenen Akkumulator 30. Zum Anschließen an eine elektrische Hilfsversorgungsvorrichtung ist ein zweiter elektrischer Anschluss 202 vorgesehen. Zum Messen und Auswerten von Parametern des angeschlossenen Akkumulators ist eine Kontrolleinheit 210 zur Gerätesteuerung (Electronic Device Control)vorgesehen, welche einen Mikrocontroller umfasst, und welche dazu ausgebildet ist, mittels eines LIN-Bus-Treibers 220 über einen an den Datenanschluss 203 angeschlossenen LIN-Bus mit einer ebenfalls an den LIN-Bus angeschlossenen Hilfsversorgungsvorrichtung zu kommunizieren. In der dargestellten Ausführungsform ist die Kontrolleinheit 210 zum Messen der Akkumulatorspannung ausgebildet und weist zu diesem Zweck entsprechende Signaleingänge auf. Ferner weist die Kontrolleinheit einen auf deren Leiterplatte angeordneten Temperatursensor 241 auf.

Vorteilhaft wird die Elektronik der Kontrolleinheit direkt an der Batteriespannung, welche beispielsweise 12 V oder 24 V beträgt, betrieben, und der LIN-Bus-Treiber stellt die Versorgungsspannung für den Mikrocontroller, beispielsweise 3,3 V oder 5 V zur Verfügung. Ein Leitungsschutzelement 230, beispielsweise als Schmelzsicherung oder MOSFET ausgebildet, schützt die Leitung zwischen Batterie 30 und Hilfsversorgungsvorrichtung gegen Kurzschluss und Überlast.

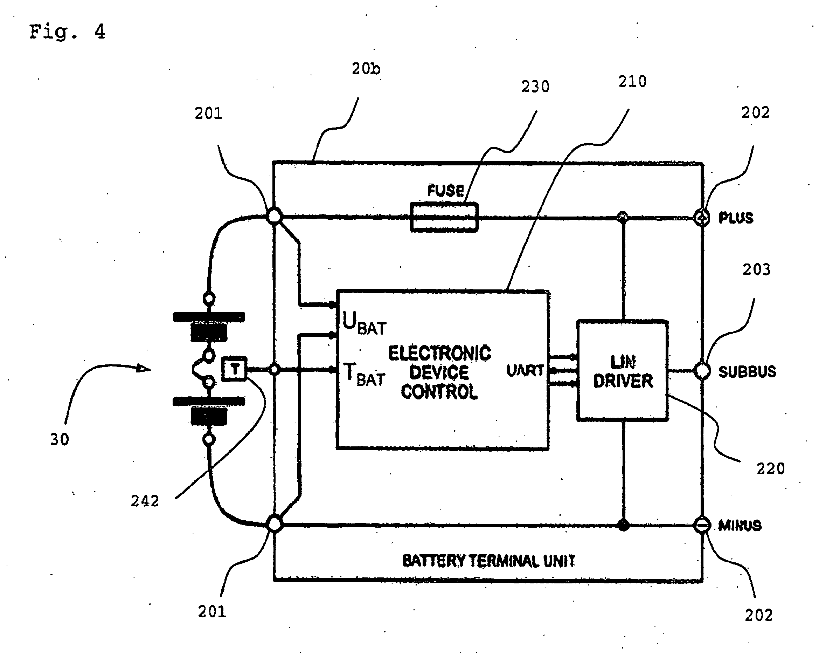

Die in Fig. 4 dargestellte Ausführungsform einer Kontrollvorrichtung 20b entspricht im Wesentlichen der in Fig. 3 gezeigten, jedoch befindet sich der Temperatursensor 242 nicht auf der Leiterplatte der Kontrolleinheit 210, sondern ist am Batteriegehäuse angeordnet und durch eine Leitung mit der Kontrolleinheit 210 verbunden.

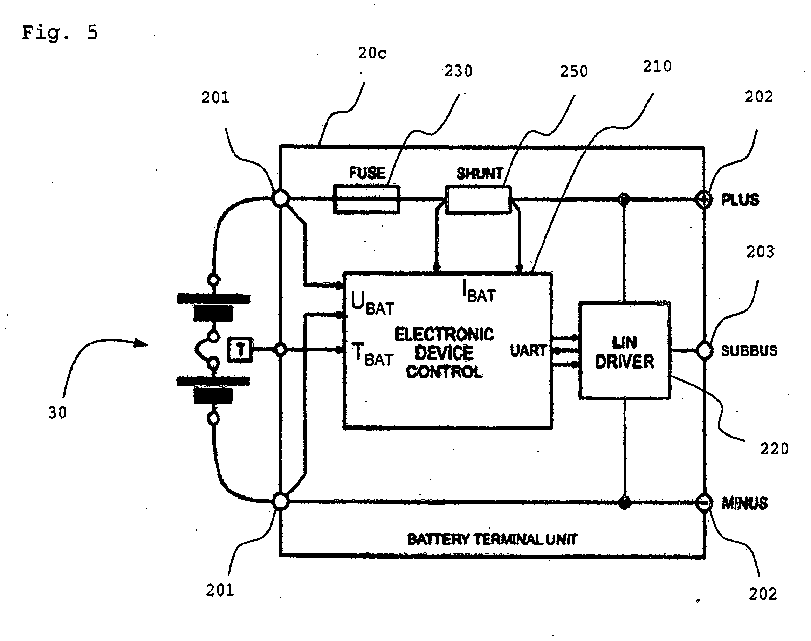

In der in Fig. 5 dargestellten Ausführungsform einer Kontrollvorrichtung 20c ist ein beispielsweise als Shunt-Widerstand ausgebildeter Stromsensor 250 vorgesehen, mit dem der Batteriestrom gemessen und ausgewertet werden kann. Somit kann direkt an der Batterie eine Ladungsbilanzierung (State Of Charge, SOC) durchgeführt werden. Die hiefür notwendigen Kenndaten der Batterie 30 sind in der Kontrolleinheit 210 nichtflüchtig gespeichert.

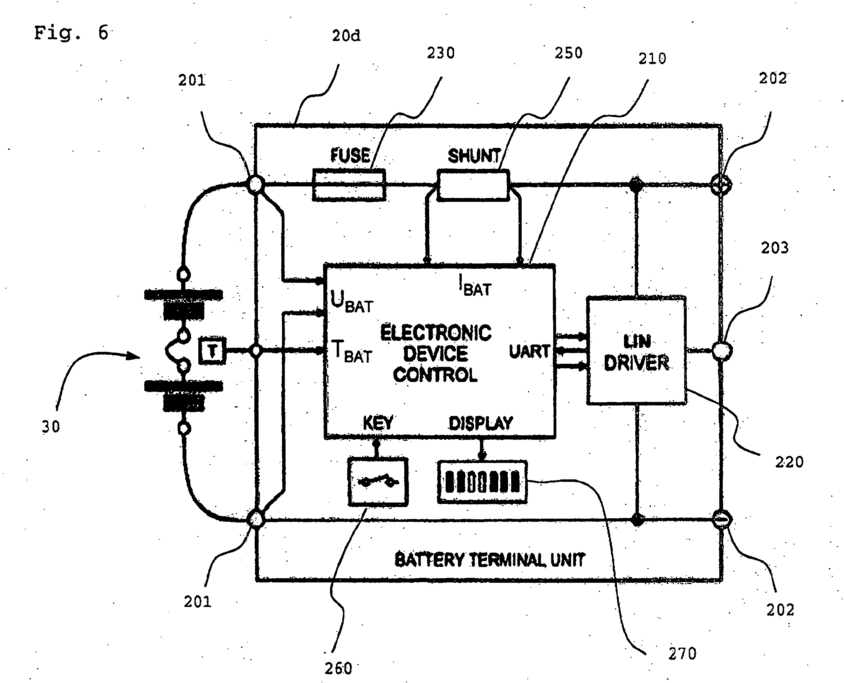

Die in Fig. 6 dargestellte Ausführungsform einer Kontrollvorrichtung 20d entspricht im Wesentlichen der in Fig. 5 gezeigten, wobei zusätzlich eine Anzeige 270, beispielsweise in Form eines LED-Bargraphen, vorgesehen ist, mit der der aktuelle Ladungsstand der Batterie 30 dargestellt werden kann. Die Anzeige 270 kann durch einen kleinen Taster 260 gestartet werden und beendet sich nach kurzer Zeit selbst, um bei einer nichtangeschlossenen Batterie 30 Energie zu sparen.

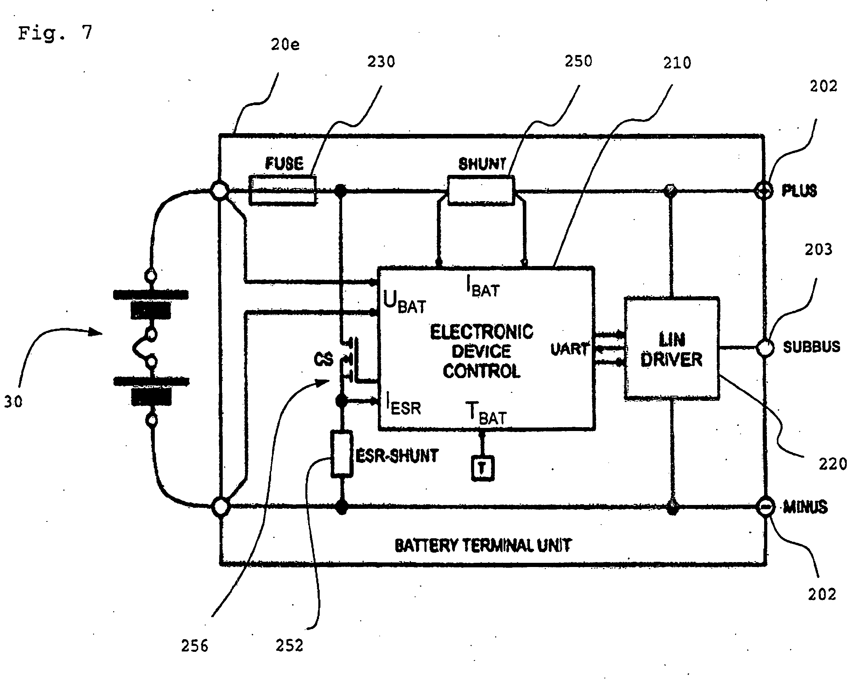

Die in Fig. 7 dargestellte Ausführungsform einer Kontrollvorrichtung 20e ist dazu ausgebildet, neben Spannung, Strom und Temperatur den Innenwiderstand (ESR) der Batterie 30 zu messen. Zu diesem Zweck ist eine schaltbare Last 252, beispielsweise als MOSFET, vorgesehen, um einen Batteriestrom fließen zu lassen, über den der Innenwiderstand (ESR) der Batterie 30 gemessen wird. Hierdurch wird die Qualität der Batterie (State Of Health, SOH, Kapazitätsverlust) ermittelt. Wenn die Stromquelle 256 eingeschaltet wird, wird die Batterie 30 mit einem zusätzlichen Strom belastet. Der Batteriestrom ist die Summe aus dem Strom des Shunts 250 und dem Strom des ESR-Shunts 252. Aus der Differenz der Batteriespannung und der Differenz des Batteriestroms kann der ESR der Batterie errechnet werden.

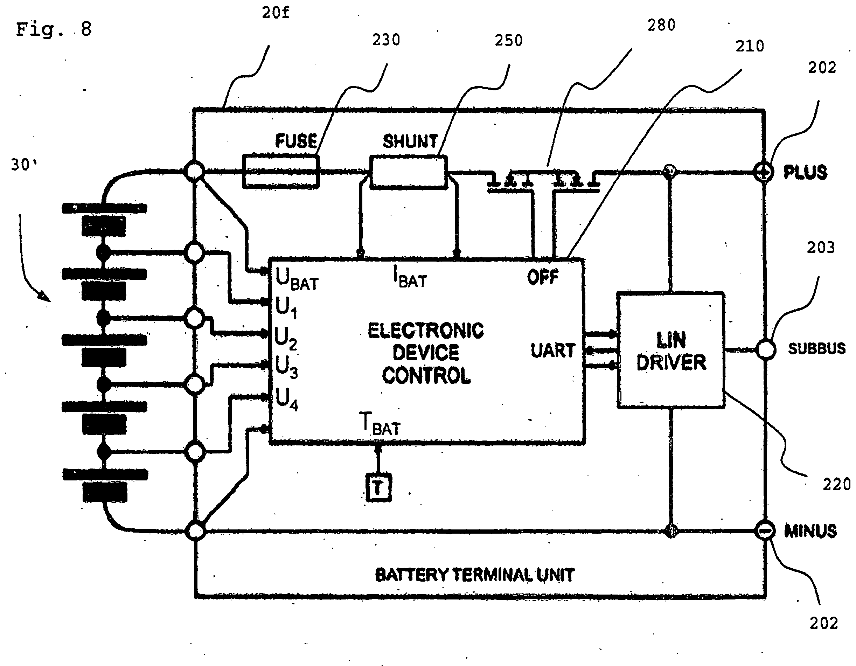

Die in Fig. 8 dargestellte Ausführungsform einer Kontrollvorrichtung 20f ist für die Verwendung einer Lithium-Ion-Batterie oder Lithium Polymer-Batterie 30' ausgebildet. In dieser Ausführungsform umfasst die Kontrolleinheit Signaleingänge zum Messen der Zellspannungen sowie eine Einrichtung zum Balancieren der Batteriezellen. Ferner ist die Kontrolleinheit 210 dazu ausgebildet, die Batterie 30' bei Überladung, Tiefentladung oder Kurzschluss mittels der Einrichtung 280 von der Hilfsversorgungsvorrichtung zu trennen. Ein solcher Fehlerzustand wird vorzugsweise der Hilfsversorgungsvorrichtung 10 über die Buskommunikation gemeldet.

## Patentansprüche

1. System zur elektrischen Hilfsversorgung, umfassend
- eine elektrische Hilfsversorgungsvorrichtung (10), und
- wenigstens einen an die elektrische Hilfsversorgungsvorrichtung (10) entfernt angeschlossenen Akkumulator (30), wobei jedem Akkumulator (30) eine zugeordnete Akkumulator-Kontrollvorrichtung (20) lokal vorgeschaltet ist, und wobei jede Akkumulator-Kontrollvorrichtung (20, 20a-20f) umfasst:
- einen ersten elektrischen Anschluss (201) zum Anschließen an einen lokalen Akkumulator,
- einen mit dem ersten elektrischen Anschluss (201) verbundenen zweiten elektrischen Anschluss (202) zum Anschließen an die entfernte elektrische Hilfsversorgungsvorrichtung (10), wobei die Akkumulator-Kontrollvorrichtung als Vorschaltgerät für den Akkumulator ausgebildet ist, und wobei die Akkumulator-Kontrollvorrichtung dazu ausgebildet ist, den Akkumulator über zwei, durch die Akkumulator-Kontrollvorrichtung geleitete, stromtragfähige Leitungen mit der elektrischen Hilfsversorgungsvorrichtung zu verbinden,
- eine Kontrolleinheit (210), welche zum Messen wenigstens eines Parameters eines an den ersten elektrischen Anschluss angeschlossenen Akkumulators und/oder eines Umgebungsparameters ausgebildet ist,
- eine Überwachungseinrichtung zum Überwachen der Zellspannungen eines angeschlossenen Lithium-Ionen- oder Lithium-Polymer-Akkumulators (30') mit einer Mehrzahl von Akkumulatorzellen,
- eine Balancer-Einrichtung zum Balancieren der Zellspannungen,
- eine Kommunikationsschnittstelle (220) zum Verbinden der Kontrolleinheit (210) mit der entfernten elektrischen Hilfsversorgungsvorrichtung (10), und
- einen nichtflüchtigen Speicher zum Speichern einer dauerhaften Identifikationsinformation, welche die Akkumulator-Kontrollvorrichtung eindeutig identifiziert und zum Speichern einer temporären Kommunikations-ID, wobei die Kontrolleinheit (210) dazu ausgebildet ist, gemessene Parameterwerte und/oder aus gemessenen Parameterwerten berechnete Werte über die Kommunikationsschnittstelle (220) zu der entfernten elektrischen Hilfsversorgungsvorrichtung (10) zu übertragen, um das Laden des Akkumulators (30) mit einer von der elektrischen Hilfsversorgungsvorrichtung (10) gesteuerten Ladeschlussspannung und/oder das Entladen des Akkumulators durch die elektrische Hilfsversorgungsvorrichtung (10) in Abhängigkeit der übertragenen Werte zu steuern, und wobei die Kontrolleinheit (210) ferner dazu ausgebildet ist, bei Erkennen einer Überladung oder Tiefentladung einer Akkumulatorzelle die Verbindung zwischen dem ersten und dem zweiten elektrischen Anschluss zu unterbrechen, und wobei
die elektrische Hilfsversorgungsvorrichtung (10) dazu ausgebildet ist, zur Adressierung jeder angeschlossenen Akkumulator-Kontrollvorrichtung (20) in Abhängigkeit der jeweiligen dauerhaften Identifikationsinformation eine temporäre Kommunikations-ID zuzuweisen.

2. Verfahren zum Kontrollieren eines Systems zur elektrischen Hilfsversorgung nach Anspruch 1, wobei das Laden und/oder Entladen des wenigstens einen entfernt angeschlossenen Akkumulators (30, 30') durch die elektrische Hilfsversorgungsvorrichtung (10) in Abhängigkeit wenigstens eines gemessenen und/oder aus Messgrößen berechneten Parameters gesteuert wird, und wobei der wenigstens eine Parameter von der zugeordneten Akkumulator-Kontrollvorrichtung (20) an die elektrische Hilfsversorgungsvorrichtung (10) übermittelt wird, und wobei in jeder Akkumulator-Kontrollvorrichtung (20) eine eindeutige und dauerhafte Identifikationsinformation hinterlegt ist, und wobei die elektrische Hilfsversorgungsvorrichtung (10) zur Adressierung jeder angeschlossenen Akkumulator-Kontrollvorrichtung (20) in Abhängigkeit der jeweiligen dauerhaften Identifikationsinformation eine temporäre Kommunikations-ID zuweist.

3. Verfahren nach Anspruch 2, wobei die Parameterübermittlung auf Anforderung der elektrischen Hilfsversorgungsvorrichtung und/oder in vorgegebenen Zeitabständen erfolgt.

4. Verfahren nach einem der vorstehenden Ansprüche, wobei der wenigstens eine Parameter
- eine Akkumulatorspannung,
- einen Akkumulatorstrom,
- einen Innenwiderstand eines Akkumulators,
- einen Ladezustand eines Akkumulators, und/oder
- einen Umgebungsparameter umfasst.

## Claims

1. A system for auxiliary electrical power supply, comprising:
- an auxiliary electrical power supply device (10); and
- at least one accumulator (30) remotely connected to the auxiliary electrical power supply device (10); wherein each accumulator (30) has an associated accumulator control device (20) connected locally upstream thereof, and wherein
each accumulator control device (20, 20a - 20f), comprises:
- a first electrical terminal (201) for connection to a local accumulator;
- a second electrical terminal (202) connected to the first electrical terminal (201), for connection to the remote auxiliary electrical power supply device (10), wherein the accumulator control device is configured as a device for connecting upstream of the accumulator, and wherein the accumulator control device is configured to connect the accumulator to the auxiliary electrical power supply device via two conductors capable of carrying current, said conductors being led through the accumulator control device;
- a control unit (210) configured to measure at least one parameter of an accumulator connected to the first electrical terminal and/or an environmental parameter;
- a monitoring device for monitoring cell voltages of a connected lithium ion accumulator or lithium polymer accumulator (30') having a plurality of accumulator cells;
- a balancer device for balancing the cell voltages;
- a communication interface (220) for connecting the control unit (210) to the remote auxiliary electrical power supply device (10); and
- a non-volatile memory for storing a permanent identification information uniquely identifying the accumulator control device, and for storing a temporary communication ID, wherein
the control unit (210) is configured to transmit measured parameter values and/or values calculated from measured parameter values to the remote auxiliary electrical power supply device (10) via the communication interface (220) to control the charging of the accumulator (30) with a charging end voltage set by the auxiliary electrical power supply device (10) and/or the discharging of the accumulator (30) by the auxiliary electrical power supply device (10) in response to the transmitted values, and wherein the control unit (210) is further configured to interrupt the connection between the first and second electrical terminals if an overcharge or deep discharge of an accumulator cell is detected, and wherein, for addressing, the auxiliary electrical power supply device (10) is configured to assign a temporary communication ID to each connected accumulator control device (20) on the basis of the respective permanent identification information.

2. A method for controlling a system for auxiliary electrical power supply according to claim 1, wherein the charging and/or discharging of the at least one remotely connected accumulator (30, 30') is controlled by the auxiliary electrical power supply device (10) on the basis of at least one measured parameter and/or a parameter calculated from measured parameters, and wherein the at least one parameter is transmitted from the associated accumulator control device (20) to the auxiliary electrical power supply device (10), and wherein each accumulator control device (20) stores a unique and permanent identification information, and wherein, for addressing, the auxiliary electrical power supply device (10) assigns a temporary communication ID to each connected accumulator control device (20) on the basis of the respective permanent identification information.

3. The method according to claim 2, wherein the parameter transmission is performed on demand from the auxiliary electrical power supply device and/or at predetermined time intervals.

4. The method according to any of the preceding claims, wherein the at least one parameter comprises
- an accumulator voltage;
- an accumulator current;
- an internal resistance of an accumulator;
- a state of charge of an accumulator; and/or
- an environmental parameter.

## Revendications

1. Système d'alimentation électrique auxiliaire, comprenant :
- un dispositif d'alimentation électrique auxiliaire (10), et
- au moins un accumulateur (30) raccordé à distance au dispositif d'alimentation électrique auxiliaire (10), dans lequel un dispositif de contrôle d'accumulateur (20) assigné étant localement disposé en amont de chaque accumulateur (30), et dans lequel chaque dispositif de contrôle d'accumulateur (20, 20a-20f) comprend:
- une première connexion électrique (201) pour le branchement d'un accumulateur local,
- une deuxième connexion électrique (202) reliée à la première connexion électrique (201) pour le branchement d'un dispositif d'alimentation électrique auxiliaire distant (10), dans lequel le dispositif de contrôle d'accumulateur est désigné comme un unité pour connecter avant l'accumulateur, et dans lequel le dispositif de contrôle d'accumulateur est prévu pour connecter l'accumulateur au dispositif d'alimentation électrique auxiliaire par deux lignes de transport de courant passant par le dispositif de contrôle d'accumulateur,
- une unité de contrôle (210) prévue pour la mesure d'au moins un paramètre d'un accumulateur branché sur la première connexion électrique et/ou d'un paramètre d'environnement,
- un dispositif de surveillance destiné à surveiller les tensions des cellules d'un accumulateur lithium-ion ou lithium-polymère (30') connecté, pourvu d'une pluralité de cellules d'accumulateur,
- un dispositif d'équilibrage destiné à équilibrer les tensions de cellules,
- une interface de communication (220) pour le raccordement de l'unité de contrôle (210) au dispositif d'alimentation électrique auxiliaire distant (10), et
- une mémoire non volatile pour le stockage d'une information d'identification durable identifiant de manière univoque le dispositif de contrôle d'accumulateur, et pour le stockage d'un identificateur de communication temporaire, dans lequel l'unité de contrôle (210) est prévue pour transmettre au dispositif d'alimentation électrique auxiliaire distant (30) des valeurs de paramètres mesurées et/ou des valeurs calculées à partir de valeurs de paramètres mesurées via l'interface de communication (220), afin de commander la charge de l'accumulateur (30) avec une tension de fin de charge réglée par le dispositif d'alimentation électrique auxiliaire (10) et/ou la décharge de l'accumulateur (30) par le dispositif d'alimentation électrique auxiliaire (10) en fonction des valeurs transmises, et dans lequel l'unité de contrôle (210) est également prévue pour interrompre la connexion entre la première et la deuxième connexion électrique si une surcharge ou une décharge profonde d'une cellule d'accumulateur est détectée, et dans lequel le dispositif d'alimentation électrique auxiliaire (10) est prévu pour affecter un identificateur de communication temporaire pour l'adressage de chaque dispositif de contrôle d'accumulateur (20) connecté en fonction de l'information d'identification durable respective.

2. Procédé de commande d'un système d'alimentation électrique auxiliaire selon la revendication 1, dans lequel la charge et/ou la décharge par le dispositif d'alimentation électrique auxiliaire (10) dudit au moins un accumulateur (30, 30') raccordé à distance sont commandées en fonction d'au moins un paramètre mesuré et/ou calculé à partir de grandeurs de mesure, et dans lequel ledit au moins un paramètre est transmis par le dispositif de contrôle d'accumulateur (20) assigné au dispositif d'alimentation électrique auxiliaire (10), et dans lequel une information d'identification univoque et durable est stockée dans chaque dispositif de contrôle d'accumulateur (20), et dans lequel le dispositif d'alimentation électrique auxiliaire (10) affecte un identificateur de communication temporaire pour l'adressage de chaque dispositif de contrôle d'accumulateur (20) connecté en fonction de l'information d'identification durable respective.

3. Procédé selon la revendication 2, dans lequel la transmission de paramètres est effectuée sur demande du dispositif d'alimentation électrique auxiliaire et/ou à des intervalles temporels définis.

4. Procédé selon l'une des revendications précédentes, dans lequel ledit au moins un paramètre comprend :
- une tension d'accumulateur,
- un courant d'accumulateur,
- une résistance interne d'un accumulateur,
- un état de charge d'un accumulateur, et/ou
- un paramètre d'environnement.
